# FASCICULE DE BREVET EUROPEEN

(11) **EP 3 596 825 B1**
(45) Date de publication et mention de la délivrance du brevet: **30.03.2022**
(21) Numéro de dépôt: 18712986.1
(22) Date de dépôt: 09.03.2018
(51) Int. Cl.: H03H 9/02

(54) **RESONATEUR SAW A COUCHES D'ATTENUATION D'ONDES PARASITES**
SÄGE-RESONATOR MIT SCHICHTEN ZUR DÄMPFUNG PARASITÄRER WELLEN
SAW RESONATOR COMPRISING LAYERS FOR ATTENUATING PARASITIC WAVES

(30) Priorité: 13.03.2017 FR 1752043
(43) Date de publication de la demande: 22.01.2020
(73) Titulaire: Commissariat à l'énergie atomique et aux énergies alternatives, 75015 Paris (FR); Soitec, 38190 Bernin (FR)
(72) Inventeur: VO, Thu Trang, 38000 Grenoble (FR); MOULET, Jean-Sébastien, 73000 Chambery (FR); REINHARDT, Alexandre, 38400 Saint-Martin-d'Heres (FR); HUYET, Isabelle, 38920 Crolles (FR); DROUIN, Alexis, 38530 La Buissiere (FR); SINQUIN, Yann, 38000 Grenoble (FR)
(74) Mandataire: Brevalex
(86) Numéro de dépôt international: PCT/FR2018/050559
(87) Numéro de publication internationale: WO 2018/167407

(56) Documents cités:
- EP-A2- 0 088 204
- US-A- 4 364 017
- US-A1- 2006 202 781
- US-A1- 2014 145 558

## Description

### DOMAINE TECHNIQUE ET ART ANTÉRIEUR

L'invention concerne le domaine des résonateurs SAW (« Surface Acoustic Wave », ou à onde acoustique de surface), utilisés notamment pour réaliser des filtres SAW.

Il est connu de réaliser un filtre SAW à partir d'une couche massive de LTO (Tantalate de Lithium). Un tel filtre est réalisé sur un substrat massif de LTO, qui est un matériau piézoélectrique, sur laquelle un jeu d'électrodes est disposé. Ce type de filtre présente toutefois certains inconvénients tels qu'une dérive thermique en fréquence importante qui est due notamment au coefficient de dilatation thermique élevé du LTO (8 fois plus important que celui du silicium).

Une solution à cette problématique est de réaliser le filtre SAW non pas à partir d'un substrat massif de LTO, mais en reportant une couche mince de LTO sur un substrat de silicium, directement ou via une couche intermédiaire de SiO₂ interposée entre le substrat et la couche mince piézoélectrique. Ce report bride mécaniquement le LTO, limitant donc sa dilatation thermique élevée et ainsi réduisant la dérive thermique en fréquence du filtre. Un exemple d'un tel filtre SAW est divulgué dans le document US2006/202781.

Cette alternative offre la possibilité de répondre à des exigences de plus en plus drastiques dues à la multiplication des bandes de fréquences utilisées pour les filtres SAW. Cela permet une diminution de la dérive en température des composants réalisés, permettant d'élargir les applications des filtres SAW vers des dispositifs utilisant actuellement la technologie BAW (« Bulk Acoustic Wave », ou ondes acoustiques de volume) qui présentent naturellement une dérive en température plus faible. Par rapport aux autres techniques de réduction de la dérive en température, l'utilisation de couches minces de matériaux piézoélectriques reportées sur un substrat par exemple en silicium présente l'avantage de ne pas nécessiter de couches de compensation en température supplémentaires, et donc de ne pas entraîner de dégradation des coefficients de qualité ou de coefficients de couplage électromécanique.

Malgré les avantages apportés par un tel report de la couche de matériau piézoélectrique sur un substrat de silicium, ces filtres restent perfectibles, notamment avec ceux qui utilisent le LTO en coupe cristalline Y+42° comme matériau piézoélectrique. En effet, ce matériau a l'avantage d'avoir un très bon compromis entre son coefficient de dilatation thermique et le couplage électromécanique qu'il procure. Cependant, l'onde acoustique excitée dans certaines orientations cristallines du LTO (par exemple la couche Y+42° qui est abondamment utilisée en téléphonie mobile) est une pseudo-onde de surface qui se traduit par un guidage imparfait des ondes le long de la surface du substrat, une partie de l'énergie acoustique étant rayonnée dans la profondeur du substrat sous la forme d'ondes de volume. Dans le cas d'une couche mince de LTO reportée sur silicium, ces ondes de volume sont réfléchies aux différentes interfaces, ce qui provoque l'excitation de modes guidés dans la couche reportée et forme des parasites visibles sur la réponse électrique des résonateurs.

Ce problème se retrouve également pour des matériaux piézoélectriques autres que le LTO, dès lors que l'orientation cristalline du matériau piézoélectrique promeut l'excitation d'une pseudo-onde de surface.

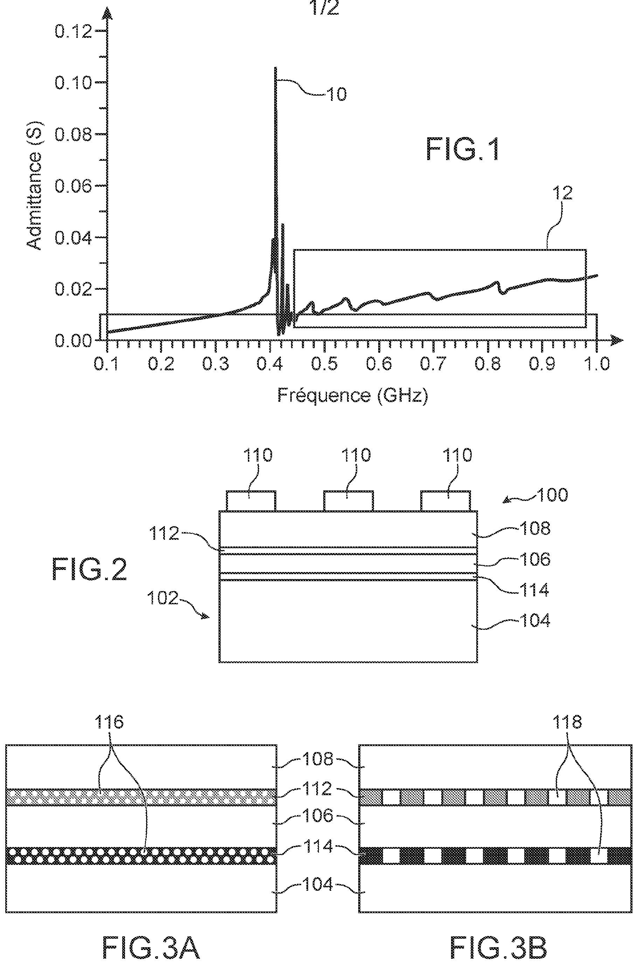

La figure 1 représente l'admittance Y, en fonction de la fréquence, d'un résonateur SAW réalisé sur une couche de LiTaO₃ reportée sur un substrat de silicium avec un film de SiO₂ utilisé comme couche de collage. Sur cette figure 1, la référence 10 désigne le pic de résonance obtenu à la fréquence de résonance du résonateur, et la référence 12 désigne les fréquences parasites.

Il serait souhaitable d'obtenir un filtre dont la réponse fréquentielle ne comporte pas ces résonances parasites.

### EXPOSÉ DE L'INVENTION

Un but de la présente invention est de proposer une solution pour supprimer, ou au moins limiter ou réduire, les ondes acoustiques parasites présentes dans la réponse fréquentielle du résonateur.

Pour cela, la présente invention propose un résonateur SAW selon la revendication 1.

Dans un tel résonateur, l'interface entre la couche de matériau piézoélectrique et le substrat et/ou, lorsque le substrat comporte au moins deux couches de matériaux différents, l'interface entre les couches du substrat, est remplacée par au moins une couche d'atténuation apte à atténuer tout ou partie du couplage entre les ondes de surface générées dans le matériau piézoélectrique et les modes guidés dans le substrat, afin de ne plus exciter ces modes guidés dans la couche de matériau piézoélectrique. Une couche d'atténuation correspond à une couche qui, par exemple, diffuse ou absorbe au moins une partie des ondes acoustiques parasites. Les ondes parasites sont ainsi supprimées ou au moins atténuées par la ou les couches d'atténuation présentes entre la couche de matériau piézoélectrique et le substrat et/ou entre deux couches du substrat.

Dans ce résonateur, lorsque le substrat comporte N couches empilées, avec N ≥ 2, il est possible d'avoir N-1 couches d'atténuation chacune disposée entre deux couches consécutives du substrat. De plus, il est possible d'avoir plusieurs couches d'atténuation superposées disposées entre deux couches consécutives du substrat.

De manière avantageuse, l'hétérogénéité de la ou des couches d'atténuation peut être telle que la composition de la ou des couches d'atténuation soit hétérogène. Une couche de composition hétérogène désigne une couche de matériau dont la composition n'est pas chimiquement et/ou physiquement homogène, ou constante, dans l'ensemble de son volume. Autrement dit, une couche de composition hétérogène correspond à une couche de matériau présentant en son sein des disparités chimiques et/ou physiques. Cette hétérogénéité de la composition de la ou des couches d'atténuation peut être telle que les ondes parasites de fréquences supérieures à la fréquence de résonance du résonateur sont au moins atténuées, voire supprimées grâce à la présence de la ou des couches d'atténuation au sein de l'empilement de couches du résonateur.

En variante, une couche d'atténuation hétérogène peut correspondre à une couche ayant au moins une partie d'au moins une de ses faces comprenant des structurations, ou rugosités. Autrement dit, une couche hétérogène peut correspondre à une couche de matériau présentant, au niveau d'au moins une partie d'au moins une de ces faces, des variations physiques de type rugosité ou structuration. Cette hétérogénéité d'une ou plusieurs faces de la ou des couches d'atténuation peut être telle que les ondes parasites de fréquences supérieures à la fréquence de résonance du résonateur sont au moins atténuées, voire supprimées grâce à la présence de la ou des couches d'atténuation au sein de l'empilement de couches du résonateur.

Selon une autre variante, le caractère hétérogène d'une ou des couches d'atténuation peut être dû à la fois à une composition hétérogène au sein de cette ou ces couches d'atténuation et à une ou plusieurs faces hétérogènes (c'est-à-dire comportant des structurations ou rugosités).

Chaque couche d'atténuation peut correspondre à une unique couche ou à un empilement de plusieurs couches.

De manière avantageuse, le matériau piézoélectrique peut comporter du LTO (LiTaO₃) et/ou du LNO (LiNbO₃) et/ou du quartz (SiO₂ cristallisé) et/ou de la Langatate (LGT, La₃Ga_{5,5}Ta_{0,5}O₁₄) ou de la Langasite (LGS, La₃Ga₅SiO₁₄) ou de la Langanite (LGN, La₃Ga_{5,5}Nb_{0,5}O₁₄).

Par ailleurs, le substrat peut comporter par exemple du silicium. Lorsque le substrat comporte au moins deux couches distinctes, l'une de ces couches peut comporter du silicium et l'autre du SiO₂. En variante, le substrat peut comporter du GaN, du SiC, du saphir (Al₂O₃) ou correspondre à un substrat de type semi-conducteur sur isolant comme par exemple de type SOI (« Silicon On Insulator »).

La première couche d'atténuation et/ou la deuxième couche d'atténuation peut comporter des porosités et/ou des cavités et/ou des régions dopées et/ou au moins une face au moins partiellement rugueuse ou structurée. La composition de la première couche d'atténuation et/ou de la deuxième couche d'atténuation est hétérogène lorsqu'elle comporte des porosités et/ou des cavités et/ou des régions dopées. La ou les faces au moins partiellement structurée peut correspondre à l'une ou plusieurs des faces principales de la ou des couches d'atténuation et qui sont en contact avec la couche de matériau piézoélectrique et/ou avec le substrat.

Lorsque la première couche d'atténuation et/ou la deuxième couche d'atténuation comporte des régions dopées, lesdites régions peuvent être dopées différemment du reste de la première couche d'atténuation et/ou de la deuxième couche d'atténuation.

L'une ou chacune des première et deuxième couches d'atténuation peut comporter au moins deux matériaux différents.

Lorsque la première couche d'atténuation et/ou la deuxième couche d'atténuation comporte des porosités et/ou des cavités, les porosités et/ou les cavités de la première couche d'atténuation et/ou de la deuxième couche d'atténuation peuvent avoir chacune une forme sensiblement sphérique ou cylindrique. Toutefois, des cavités et/ou des porosités d'une toute autre forme sont possibles et réalisables dans la première et/ou la deuxième couches d'atténuation.

Le résonateur SAW peut être tel que :
- la première couche d'atténuation soit distincte du substrat et de la couche de matériau piézoélectrique, ou corresponde à une partie du substrat et/ou de la couche de matériau piézoélectrique, et/ou que
- la deuxième couche d'atténuation soit distincte des deux couches du substrat, ou corresponde à une partie d'au moins une des deux couches du substrat.

La première couche d'atténuation et/ou la deuxième couche d'atténuation peuvent comporter du SiOC et/ou du SiOCH et/ou du silicium poreux et/ou un matériau organique poreux et/ou du polysilicium.

Le résonateur peut comporter en outre des électrodes disposées sur la couche de matériau piézoélectrique.

Le résonateur SAW peut être utilisé pour synthétiser un filtre SAW.

D'autres applications sont également possibles pour le résonateur SAW, par exemple utilisé dans un capteur ou un circuit délivrant au moins un signal d'horloge.

L'invention concerne également un procédé de réalisation d'un résonateur SAW, selon la revendication 7.

La réalisation de la première couche d'atténuation et/ou de la deuxième couche d'atténuation peut comporter la mise en œuvre d'un dépôt d'au moins un matériau poreux et/ou la réalisation de cavités par la mise en œuvre d'étapes de photolithographie et gravure, et/ou le dopage de régions de la première couche d'atténuation et/ou de la deuxième couche d'atténuation et/ou la mise en œuvre d'un dépôt de matériau sur une surface rugueuse, formant la première couche d'atténuation et/ou la deuxième couche d'atténuation, et/ou la mise en œuvre d'un traitement formant des rugosités au niveau d'au moins une face de la première couche d'atténuation et/ou de la deuxième couche d'atténuation.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente la réponse fréquentielle d'un filtre SAW de l'art antérieur ;
- la figure 2 représente un résonateur SAW, objet de la présente invention, selon un mode de réalisation particulier;
- les figures 3A à 3C représentent des exemples de réalisation de couches d'atténuation hétérogènes au sein d'un résonateur SAW, objet de la présente invention ;
- la figure 4 représente l'atténuation des ondes parasites obtenue en utilisant un résonateur SAW, objet de la présente invention ;
- les figures 5A et 5B des variantes de réalisation de couches d'atténuation d'un résonateur SAW, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

La figure 2 représente un résonateur SAW 100 selon un mode de réalisation particulier.

Le résonateur 100 est réalisé à partir d'un substrat 102. Ce substrat 102 comporte une ou plusieurs couches de matériaux. Sur l'exemple représenté sur la figure 2, le substrat 102 comporte une première couche 104 de matériau massive, par exemple de silicium, ainsi qu'une deuxième couche 106 comportant par exemple du SiO₂.

Le résonateur 100 comporte également une couche de matériau piézoélectrique 108 disposée sur le substrat 102, et ici sur la deuxième couche 106. Dans ce mode de réalisation particulier, le matériau piézoélectrique correspond à du LTO. En variante, le matériau piézoélectrique peut comporter du LTO et/ou du LNO (LiNbO₃) et/ou du quartz (SiO₂ cristallisé) et/ou de la Langatate (LGT, La₃Ga_{5,5}Ta_{0,5}O₁₄) et/ou de la Langasite (LGS, La₃Ga₅SiO₁₄) et/ou de la Langanite (LGN, La₃Ga_{5,5}Nb_{0,5}O₁₄).

Le résonateur 100 comporte également des électrodes 110, correspondant à des électrodes d'entrée et de sortie du résonateur 100, disposées sur la couche de matériau piézoélectrique 108. Les électrodes 110 comportent un ou plusieurs matériaux électriquement conducteurs, par exemple métalliques.

Le résonateur 100 comporte également une première couche d'atténuation 112 disposée entre le substrat 102 et la couche de matériau piézoélectrique 108, c'est-à-dire ici entre la deuxième couche 106 et la couche de matériau piézoélectrique 108.

Le résonateur 100 comporte également une deuxième couche d'atténuation 114 disposée entre les deux couches 104, 106 du substrat 102.

Dans le mode de réalisation particulier décrit ici, la couche massive 104 a par exemple une épaisseur égale à plusieurs centaines de microns et correspond par exemple à l'épaisseur standard d'un substrat de silicium utilisé en microélectronique, la deuxième couche 106 a par exemple une épaisseur comprise entre environ 0 (absence de la deuxième couche 106) et 10 µm, la couche de matériau piézoélectrique 108 a par exemple une épaisseur comprise entre environ 5 µm et 50 µm, les électrodes 110 ont par exemple chacune une épaisseur comprise entre environ quelques dizaines de nanomètres et quelques centaines de nanomètres, la première couche d'atténuation 112 a par exemple une épaisseur comprise entre environ 100 nm et 10 µm, et la deuxième couche d'atténuation 114 a par exemple une épaisseur comprise entre environ 100 nm et 10 µm.

Les couches d'atténuation 112, 114 ont par exemple chacune une composition hétérogène. Ainsi, chacune des couches d'atténuation 112, 114 comporte, en son sein, des disparités physiques et/ou chimiques.

Selon un premier exemple de réalisation, cette hétérogénéité des compositions des couches d'atténuation 112, 114 est obtenue en formant, au sein de chacune des couches d'atténuation 112, 114, des régions ou zones dopées différemment du reste de ces couches 112, 114.

Selon un deuxième exemple de réalisation, cette hétérogénéité des compositions des couches d'atténuation 112, 114 est obtenue en réalisant ces couches avec un ou plusieurs matériaux poreux, tels que du SiOC et/ou du SiOCH et/ou du silicium poreux et/ou un matériau organique poreux et/ou du polysilicium. Selon un exemple de réalisation avantageux, au moins l'une des couches d'atténuation 112, 114 est formée par une couche de polymère, par exemple de la résine, qui correspond à un matériau fortement viscoélastique, et dans laquelle des trous localisés et régulièrement répartis dans la couche en formant une matrice de cavités 118 sont réalisés.

La figure 3A représente schématiquement des couches d'atténuation 112, 114 réalisées avec des matériaux poreux, les pores portant la référence 116 sur cette figure.

Selon un troisième exemple de réalisation, cette hétérogénéité des compositions des couches d'atténuation 112, 114 est obtenue en réalisant des cavités 118 au sein de ces couches. Ces cavités 118 peuvent être formées à travers au moins une partie de l'épaisseur des couches 112, 114. La figure 3B représente schématiquement des couches d'atténuation 112, 114 comportant de telles cavités 118. Ces cavités 118 sont par exemple réalisées en mettant en œuvre des étapes de photolithographie et de gravure des couches 112, 114.

Selon un quatrième exemple de réalisation, en alternative ou en combinaison de la composition hétérogène des couches d'atténuation 112, 114, l'hétérogénéité de l'une ou des couches d'atténuation 112, 114 peut être également obtenue grâce à une interface rugueuse de l'une ou des couches d'atténuation 112, 114.

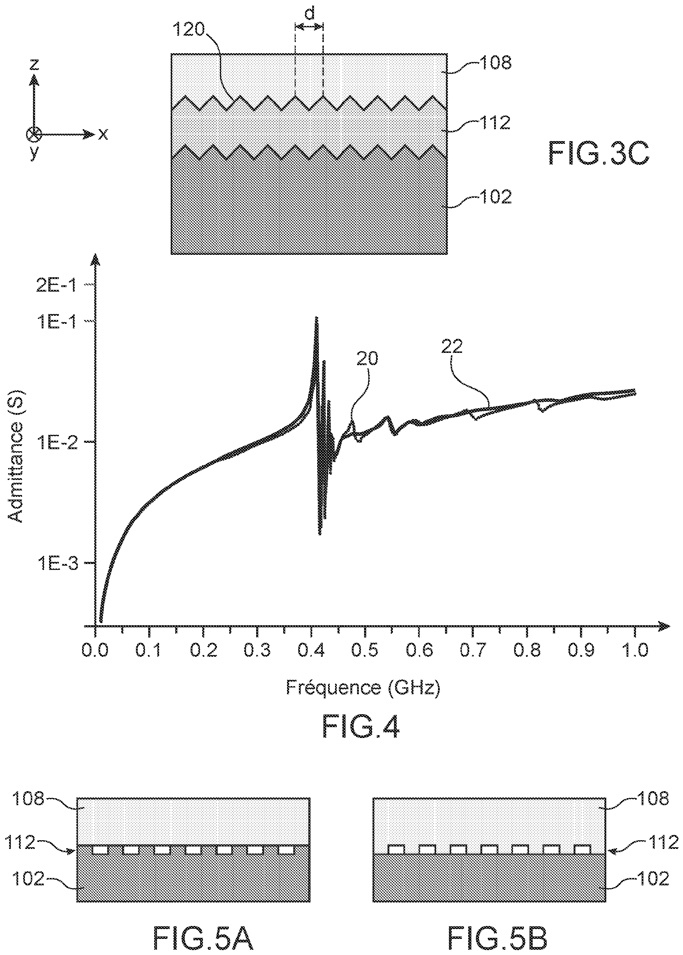

La figure 3C représente schématiquement la couche d'atténuation 112 disposée entre le substrat 102 et la couche de matériau piézoélectrique 108.

L'hétérogénéité de la couche d'atténuation 112 est obtenue dans ce cas par le fait que les deux faces principales de la couche d'atténuation 112 (celle à l'interface entre la couche d'atténuation 112 et la couche piézoélectrique 108, et celle à l'interface entre la couche d'atténuation 112 et le substrat 102) comportent chacune des structurations 120, ou rugosités. En variante, il est possible qu'une seule des deux faces principales de la couche d'atténuation 112 (avantageusement celle formant l'interface avec la couche piézoélectrique 108 puisque cette face est la plus proche des ondes parasites à atténuer) comporte les structurations 120. Sur la figure 3C, ces structurations 120 sont réalisées initialement sur la face supérieure du substrat 102, puis se retrouvent ensuite sur les deux faces de la couche d'atténuation 112 grâce au dépôt de cette couche sur ces structurations.

En outre, la couche d'atténuation 114 se trouvant entre les deux couches 104, 106 du substrat 102 peut également comporter des structurations, par exemple similaires aux structurations 120. Enfin, pour l'une ou chacune des couches d'atténuation 112, 114, une partie seulement d'une ou de chacune de ces faces peut être structurée.

La solidarisation des couches d'atténuation 112, 114 avec les autres couches du résonateur 100 peut être obtenue par collage direct, ou collage moléculaire, ou directement par un dépôt de ces couches sur le support souhaitée (par exemple la couche 104 ou la couche 106).

Ces différents exemples de réalisation permettant d'obtenir des couches d'atténuation 112, 114 de compositions hétérogènes ou comportant une interface rugueuse ne sont pas exclusifs les uns par rapport aux autres. Ainsi, l'une ou les deux couches d'atténuation 112, 114 peuvent avoir une composition hétérogène obtenue grâce à la présence de régions dopées différemment du reste de ces couches 112, 114 et/ou de pores 116 et/ou de cavités 118, ces différentes hétérogénéités pouvant être combinées au sein d'une même couche d'atténuation, avec éventuellement une ou plusieurs interfaces rugueuses.

En outre, l'hétérogénéité de la première couche d'atténuation 112 peut être de nature similaire ou non à celle de la deuxième couche d'atténuation 114. Par exemple, il est possible que l'hétérogénéité de la composition de la première couche d'atténuation 112 soit obtenue grâce à l'utilisation d'au moins un matériau poreux pour former la première couche d'atténuation 112, et que l'hétérogénéité de la composition de la deuxième couche d'atténuation 114 soit obtenue grâce à la réalisation de cavités au sein de la deuxième couche d'atténuation 114.

Les pores 116 et/ou les cavités 118 et/ou les zones dopées de la première couche d'atténuation 112 et/ou de la deuxième couche d'atténuation 114 ont par exemple chacun une forme sensiblement sphérique ou cylindrique (de section polygonale ou circulaire). En outre, les pores 116 et/ou les cavités 118 sont avantageusement remplis d'air ou encore d'un autre matériau.

De manière générale, la taille et la forme des pores 116, des cavités 118 et des zone dopées peuvent variées en fonction de la ou des fréquences des ondes acoustiques parasites destinées à être atténuées et/ou absorbées, afin de maximiser cette atténuation et/ou cette absorption des ondes parasites par les couches d'atténuation 112, 114. Les dimensions des pores 116 et/ou des cavités 118 et/ou des zones dopées formées au sein des couches d'atténuation 112, 114 sont par exemple comprises entre environ 10 nm et 10 µm, ce qui permet d'atténuer des ondes acoustiques parasites de fréquence de l'ordre d'1 GHz, ou par exemple comprises entre 0, 1 et 10 GHz. Par exemple, pour réaliser une absorption de fréquences parasites de l'ordre de 500 MHz, des cavités 118 de forme cylindrique de diamètre égale à environ 2 µm et de hauteur comprise entre environ 5 µm et 10 µm peuvent être réalisées.

De manière générale, lorsqu'une couche d'atténuation comporte des structurations ou rugosités, les motifs de ces structurations ou rugosités peuvent être de forme quelconque, et par exemple aléatoire. De plus, la hauteur, ou l'amplitude, de ces structurations ou rugosités (dimension parallèle à l'axe Z représenté sur la figure 3C) est par exemple d'au moins 500 nm et par exemple comprise entre environ 500 nm et 3 µm, ou avantageusement comprise entre environ 1 µm et 2 µm. Le pas entre deux structurations, c'est-à-dire la période de répétition de ces structurations, est par exemple au moins comprise entre environ 100 nm et 10 µm. Cette périodicité est représentée sur la figure 3C par la distance d séparant deux sommets de deux structurations voisines.

La courbe 20 représentée sur la figure 4 correspond à l'admittance Y d'un résonateur SAW de référence ne comportant pas de couche d'atténuation. La courbe 22 correspond à l'admittance Y obtenue lorsqu'une couche d'atténuation 112 ayant ses deux faces rugueuses est insérée entre la couche de matériau piézoélectrique 108 et le substrat 102. Ces courbes 20 et 22 montrent que les ondes parasites sont atténuées en présence d'une telle couche d'atténuation 112. Dans l'exemple décrit ici, la gamme de fréquences dans laquelle la couche d'atténuation 112 est efficace est comprise entre 0 et 1 GHz.

En outre, l'efficacité des couches d'atténuation 112, 114 est améliorée lorsqu'un effet de résonance acoustique de l'air ou d'un fluide (eau, azote, etc.) remplissant les pores 116 et/ou les cavités 118 est obtenu. Pour cela, les dimensions des pores 116 et/ou des cavités 118 peuvent être égales à environ la moitié de la longueur d'onde acoustique dans le fluide aux fréquences d'intérêt. Par exemple, pour une résonance de l'ordre d'1 GHz, des pores 116 remplis d'air peuvent présenter un diamètre compris entre environ 100 nm et 200 nm.

En variante, le substrat 102 peut comporter une seule couche de matériau correspondant à la première couche 104. Dans ce cas, le résonateur 100 comporte une seule couche d'atténuation 112 disposée entre la couche de matériau piézoélectrique 108 et la première couche 104.

Selon une autre variante, le substrat 102 peut comporter plus de deux couches de matériaux. Dans ce cas, le résonateur 100 peut comporter plus deux couches d'atténuation de composition hétérogène, chacune des couches d'atténuation étant disposée soit entre deux couches du substrat 102, soit entre la couche de matériau piézoélectrique 108 et le substrat 102 pour l'une de ces couches d'atténuation.

Il est également possible que chaque couche d'atténuation corresponde à un empilement de plusieurs couches différentes comportant des matériaux différents et/ou des compositions hétérogènes différentes d'une couche à l'autre.

Dans le mode de réalisation particulier décrit ci-dessus, chacune des couches d'atténuation 112, 114 correspond à une couche distincte du substrat 102 et de la couche de matériau piézoélectrique 108. En variante, il est possible qu'au moins l'une des couches d'atténuation 112, 114 corresponde à une partie du substrat 102 et/ou de la couche de matériau piézoélectrique 108 ayant subi une modification locale de la nature du substrat 102 et/ou de la couche de matériau piézoélectrique 108.

Par exemple, comme représenté sur le schéma de la figure 5A, la couche d'atténuation 112 est formée en ayant structuré la face supérieure (celle destinée à être disposée du côté de la couche de matériau piézoélectrique 108) du substrat 102 via des étapes de photolithographie et de gravure. La partie supérieure structurée du substrat 102 forme la couche d'atténuation 112 sur laquelle la couche de matériau piézoélectrique 108 est ensuite solidarisée, par exemple par collage direct, ou collage moléculaire. Sur le schéma de la figure 5B, la couche d'atténuation 112 est formée en ayant structuré la face inférieure (celle destinée à être disposée du côté du substrat 102) de la couche de matériau piézoélectrique 108 via des étapes de photolithographie et de gravure. La partie inférieure structurée de la couche de matériau piézoélectrique 108 forme la couche d'atténuation 112 qui est solidarisée sur le substrat 102, par exemple par collage direct ou collage moléculaire.

## Revendications

1. Résonateur à ondes acoustiques de surface, SAW, (100) comportant au moins :
- un substrat (102) ;
- une couche de matériau piézoélectrique (108) disposée sur le substrat (102) ;
- une première couche d'atténuation (112) disposée entre le substrat (102) et la couche de matériau piézoélectrique (108) et/ou, lorsque le substrat (102) comporte au moins deux couches distinctes (104, 106), une deuxième couche d'atténuation (114) disposée entre les deux couches (104, 106) du substrat (102) ;
et dans lequel la ou les couches d'atténuation (112, 114) sont aptes à diffuser ou absorber au moins une partie d'ondes acoustiques parasites et comportent du silicium poreux et/ou du polysilicium dans lequel se trouvent des régions dopées rendant la ou les couches d'atténuation (112, 114) hétérogènes.

2. Résonateur SAW (100) selon la revendication 1, dans lequel la couche de matériau piézoélectrique (108) comporte du LTO et/ou du LNO et/ou du quartz et/ou de la Langatate et/ou de la Langasite et/ou de la Langanite.

3. Résonateur SAW (100) selon l'une des revendications précédentes, dans lequel le silicium poreux et/ou le polysilicium de la première couche d'atténuation (112) et/ou de la deuxième couche d'atténuation (114) est dopé et lesdites régions dopées sont dopées différemment du reste de la première couche d'atténuation (112) et/ou de la deuxième couche d'atténuation (114).

4. Résonateur SAW (100) selon l'une des revendications précédentes, dans lequel la première couche d'atténuation (112) et/ou la deuxième couche d'atténuation (114) comporte des cavités (118) et/ou au moins une face au moins partiellement rugueuse.

5. Résonateur SAW (100) selon la revendication 4, dans lequel, lorsque la première couche d'atténuation (112) et/ou la deuxième couche d'atténuation (114) comporte des cavités (118), les cavités (118) de la première couche d'atténuation (112) et/ou de la deuxième couche d'atténuation (114) ont chacune une forme sensiblement sphérique ou cylindrique.

6. Résonateur SAW (100) selon l'une des revendications précédentes, dans lequel :
- la première couche d'atténuation (112) est distincte du substrat (102) et de la couche de matériau piézoélectrique (108), ou fait partie du substrat (102) et/ou de la couche de matériau piézoélectrique (108), et/ou
- la deuxième couche d'atténuation (114) est distincte des deux couches (104, 106) du substrat (102), ou fait partie d'au moins une des deux couches (104, 106) du substrat (102).

7. Procédé de réalisation d'un résonateur à ondes acoustiques de surface, SAW, (100), comportant au moins la mise en œuvre des étapes suivantes:
- réalisation d'une première couche d'atténuation (112) sur un substrat (102) et/ou, lorsque le substrat (102) comporte au moins deux couches (104, 106) distinctes, d'une deuxième couche d'atténuation (114) entre les deux couches (104, 106) du substrat (102), la ou les couches d'atténuation (112, 114) comportant du silicium poreux et/ou du polysilicium ;
- réalisation d'une couche de matériau piézoélectrique (108) sur le substrat (102) lorsque la première couche d'atténuation (112) n'est pas réalisée sur le substrat (102) ou, lorsque la première couche d'atténuation (112) est présente sur le substrat (102), sur la première couche d'atténuation (112) ;
et dans lequel la réalisation de la première couche d'atténuation (112) et/ou de la deuxième couche d'atténuation (114) comporte un dopage de régions de silicium poreux et/ou de polysilicium de la première couche d'atténuation (112) et/ou de la deuxième couche d'atténuation (114) rendant la ou les couches d'atténuation (112, 114) hétérogènes, et dans lequel la ou les couches d'atténuation (112, 114) sont aptes à diffuser ou absorber au moins une partie d'ondes acoustiques parasites.

8. Procédé selon la revendication 7, dans lequel la réalisation de la première couche d'atténuation (112) et/ou de la deuxième couche d'atténuation (114) comporte la réalisation de cavités (118) par la mise en œuvre d'étapes de photolithographie et gravure et/ou la mise en œuvre d'un dépôt de matériau sur une surface rugueuse, formant la première couche d'atténuation (112) et/ou la deuxième couche d'atténuation (114), et/ou la mise en œuvre d'un traitement formant des rugosités au niveau d'au moins une face de la première couche d'atténuation (112) et/ou de la deuxième couche d'atténuation (114).

## Patentansprüche

1. Resonator für akustische Oberflächenwellen, SAW, (100), umfassend wenigstens Folgendes:
- ein Substrat (102);
- eine Schicht aus piezoelektrischem Material (108), die auf dem Substrat (102) angeordnet ist;
- eine erste Dämpfungsschicht (112), die zwischen dem Substrat (102) und der Schicht aus piezoelektrischem Material (108) angeordnet ist, und/oder, wenn das Substrat (102) wenigstens zwei verschiedene Schichten (104, 106) umfasst, eine zweite Dämpfungsschicht (114), die zwischen den zwei Schichten (104, 106) des Substrats (102) angeordnet ist;
und wobei die Dämpfungsschicht(en) (112, 114) dazu ausgelegt sind, wenigstens einen Teil von parasitären Akustikwellen zu diffundieren oder zu absorbieren, und poröses Silizium und/oder Polysilizium umfassen, in dem sich dotierte Regionen befinden, die die Dämpfungsschicht(en) (112, 114) heterogen machen.

2. SAW-Resonator (100) nach Anspruch 1, bei dem die Schicht aus piezoelektrischem Material (108) LTO und/oder LNO und/oder Quarz und/oder Langatat und/oder Langasit und/oder Langanit umfasst.

3. SAW-Resonator (100) nach einem der vorhergehenden Ansprüche, bei dem das poröse Silizium und/oder das Polysilizium der ersten Dämpfungsschicht (112) und/oder der zweiten Dämpfungsschicht (114) dotiert ist, und die dotierten Regionen verschieden vom Rest der ersten Dämpfungsschicht (112) und/oder der zweiten Dämpfungsschicht (114) dotiert sind.

4. SAW-Resonator (100) nach einem der vorhergehenden Ansprüche, bei dem die erste Dämpfungsschicht (112) und/oder die zweite Dämpfungsschicht (114) Hohlräume (118) und/oder wenigstens eine Fläche umfasst, die wenigstens teilweise rau ist.

5. SAW-Resonator (100) nach Anspruch 4, bei dem dann, wenn die erste Dämpfungsschicht (112) und/oder die zweite Dämpfungsschicht (114) Hohlräume (118) umfasst, die Hohlräume (118) der ersten Dämpfungsschicht (112) und/oder der zweiten Dämpfungsschicht (114) jeweils eine im Wesentlichen sphärische oder zylindrische Form haben.

6. SAW-Resonator (100) nach einem der vorhergehenden Ansprüche, bei dem:
- die erste Dämpfungsschicht (112) von dem Substrat (102) und von der Schicht aus piezoelektrischem Material (108) verschieden ist, oder ein Teil des Substrats (102) und/oder der Schicht aus piezoelektrischem Material (108) ist, und/oder
- die zweite Dämpfungsschicht (114) von den zwei Schichten (104, 106) des Substrats (102) verschieden ist, oder ein Teil von wenigstens einer der zwei Schichten (104, 106) des Substrats (102) ist.

7. Verfahren zur Herstellung eines Resonators für akustische Oberflächenwellen, SAW, (100), umfassend wenigstens die Durchführung der folgenden Schritte:
- Realisieren einer ersten Dämpfungsschicht (112) auf einem Substrat (102) und/oder, wenn das Substrat (102) wenigstens zwei verschiedene Schichten (104, 106) umfasst, einer zweiten Dämpfungsschicht (114) zwischen den zwei Schichten (104, 106) des Substrats (102), wobei die Dämpfungsschicht(en) (112, 114) poröses Silizium und/oder Polysilizium umfasst;
- Realisieren einer Schicht aus piezoelektrischem Material (108) auf dem Substrat (102), wenn die erste Dämpfungsschicht (112) nicht auf dem Substrat (102) realisiert ist, oder, wenn die erste Dämpfungsschicht (112) auf dem Substrat (102) vorhanden ist, auf der ersten Dämpfungsschicht (112);
und wobei die Realisierung der ersten Dämpfungsschicht (112) und/oder der zweiten Dämpfungsschicht (114) eine Dotierung von Regionen aus porösem Silizium und/oder aus Polysilizium der ersten Dämpfungsschicht (112) und/oder der zweiten Dämpfungsschicht (114) umfasst, die die Dämpfungsschicht(en) (112, 114) heterogen macht, und wobei die Dämpfungsschicht(en) (112, 114) dazu ausgelegt sind, wenigstens einen Teil von parasitären Akustikwellen zu diffundieren oder zu absorbieren.

8. Verfahren nach Anspruch 7, bei dem die Realisierung der ersten Dämpfungsschicht (112) und/oder der zweiten Dämpfungsschicht (114) die Realisierung von Hohlräumen (118) umfasst mittels Durchführung von Schritten der Photolithographie und des Ätzens und/oder der Durchführung einer Abscheidung von Material auf einer rauen Oberfläche, wodurch die erste Dämpfungsschicht (112) und/oder die zweite Dämpfungsschicht (114) gebildet wird, und/oder der Durchführung einer Behandlung, die Rauigkeiten im Bereich wenigstens einer Fläche der ersten Dämpfungsschicht (112) und/oder der zweiten Dämpfungsschicht (114) bildet.

## Claims

1. Surface acoustic wave resonator, SAW, (100) comprising at least:
- one substrate (102);
- one layer of piezoelectric material (108) arranged on the substrate (102);
- one first attenuation layer (112) arranged between the substrate (102) and the layer of piezoelectric material (108) and/or, when the substrate (102) comprises at least two separate layers (104, 106), one second attenuation layer (114) arranged between the two layers (104, 106) of the substrate (102);
and wherein the attenuation layer or layers (112, 114) are able to diffuse or absorb at least one portion of parasitic acoustic waves and comprise porous silicon and/or polysilicon in which are arranged doped regions that render the attenuation layer or layers (112, 114) heterogeneous.

2. SAW resonator (100) according to claim 1, wherein the layer of piezoelectric material (108) comprises LTO and/or LNO and/or quartz and/or Langatate and/or Langasite and/or Langanite.

3. SAW resonator (100) according to one of the preceding claims, wherein the porous silicon and/or the polysilicon of the first attenuation layer (112) and/or of the second attenuation layer (114) is doped and said doped regions are doped differently from the rest of the first attenuation layer (112) and/or of the second attenuation layer (114).

4. SAW resonator (100) according to one of the preceding claims, wherein the first attenuation layer (112) and/or the second attenuation layer (114) comprises cavities (118) and/or at least one face at least partially rough.

5. SAW resonator (100) according to claim 4, wherein, when the first attenuation layer (112) and/or the second attenuation layer (114) comprises cavities (118), the cavities (118) of the first attenuation layer (112) and/or of the second attenuation layer (114) each have a substantially spherical or cylindrical shape.

6. SAW resonator (100) according to one of the preceding claims, wherein:
- the first attenuation layer (112) is separate from the substrate (102) and from the layer of piezoelectric material (108), or corresponds to a portion of the substrate (102) and/or of the layer of piezoelectric material (108), and/or
- the second attenuation layer (114) is separate from the two layers (104, 106) of the substrate (102), or corresponds to a portion of at least one of the two layers (104, 106) of the substrate (102).

7. Method for producing a surface acoustic wave resonator, SAW, (100), comprising at least the implementation of the following steps:
- production of a first attenuation layer (112) on a substrate (102) and/or, when the substrate (102) comprises at least two separate layers (104, 106), of a second attenuation layer (114) between the two layers (104, 106) of the substrate (102), the attenuation layer or layers (112, 114) comprising porous silicon and/or polysilicon;
- production of a layer of piezoelectric material (108) on the substrate (102) when the first attenuation layer (112) is not produced on the substrate (102) or, when the first attenuation layer (112) is present on the substrate (102), on the first attenuation layer (112);
and wherein the production of the first attenuation layer (112) and/or of the second attenuation layer (114) comprises a doping of regions of porous silicon and/or polysilicon of the first attenuation layer (112) and/or of the second attenuation layer (114) that renders the attenuation layer or layers (112, 114) heterogeneous, and wherein the attenuation layer or layers (112, 114) are able to diffuse or absorb at least one portion of parasitic acoustic waves.

8. Method according to claim 7, wherein the production of the first attenuation layer (112) and/or of the second attenuation layer (114) comprises the production of cavities (118) by the implementation of steps of photolithography and etching and/or the implementation of a deposit of material on a rough surface, forming the first attenuation layer (112) and/or the second attenuation layer (114), and/or the implementation of a treatment that form roughnesses on at least one face of the first attenuation layer (112) and/or of the second attenuation layer (114).
